# EUROPEAN PATENT SPECIFICATION

(11) **EP 1 276 361 B1**
(45) Date of publication and mention of the grant of the patent: **29.09.2004**
(21) Application number: 02021867.3
(22) Date of filing: 27.10.1995
(51) Int. Cl.: H05K 5/06

(54) **Waterproof casing structure for electronic equipment**
Dichte Gehäusestruktur für elektronisches Gerät
Structure de boîtier étanche pour équipement électronique

(30) Priority: 27.01.1995 JP 1145195
(43) Date of publication of application: 15.01.2003
(62) Divisional of application: 95116958.0
(73) Proprietor: MITSUBISHI DENKI KABUSHIKI KAISHA, Tokyo 100 (JP)
(72) Inventor: Saito, Koji, Mitsubishi Denki Kabushiki Kaisha, Amagasaki-shi, Hyogo 661 (JP); Inubushi, Toshiya, Mitsubishi Denki K.K., Amagasaki-shi, Hyogo 661 (JP)
(74) Representative: HOFFMANN - EITLE

(56) References cited:
- DE-A- 3 905 130
- JP-A- 4 170 098
- JP-A- 5 021 965
- JP-A- 54 139 403
- JP-A- 55 060 893
- US-A- 4 665 654
- US-A- 5 153 380

## Description

### BACKGROUND OF THE INVENTION

### FIELD OF THE INVENTION

The present invention relates to a waterproof casing structure for electronic equipment.

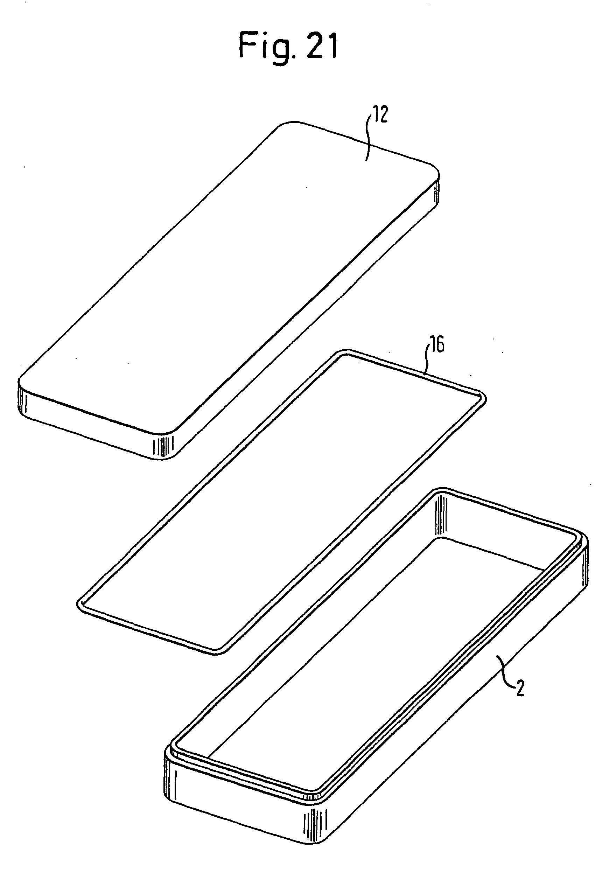

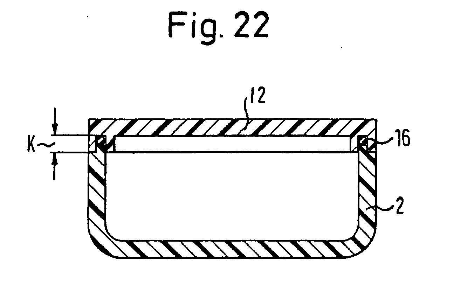

There is shown a conventional waterproof casing structure for electronic equipment in Fig. 21 and Fig. 22. Fig. 21 is a perspective view and Fig. 22 is a cross-sectional view of the casing of Fig. 21.

A box-shaped lower, first case member (2) and an upper, second case member (12) are engaged with each other as shown in Fig. 22. Between the first case member (2) and the second case member (12), an annular round rubber packing portion (16) of the second case member is held on the entire periphery of the engaging portion. The case members (2) and (12) are generally made of thermoplastic resin.

In this conventional waterproof structure, a groove portion for accommodating the waterproof packing portion (16) must be provided in the upper, second case member (12) and a projection to press the waterproof packing portion (16) is needed in the lower, first case member (2). Therefore, the overlapping distance designated as K in Fig. 22 adds thickness to the casing. This kind of structure makes it difficult to reduce the thickness of the casing, even when a reduced thickness is desired.

Further, if the casing is of a complicated form, the waterproof packing also has a complicated form, making it difficult to insert and assemble the waterproof packing.

Further, when the size of the casing is reduced, the thickness of diameter of the waterproof packing must also be reduced. However, such a waterproof packing having a small diameter may be readily deformed or broken when assembled.

### ILLUSTRATIVE EXAMPLES

The examples presented here below are not part of the invention but are useful for understanding it.

According to one example there is provided a waterproof casing for electronic equipment, said casing comprising a first case member and a second case member engageable with the first case member to form a casing for accommodation; and wherein the second case member comprises a lid movably mounted on the first case member for opening and closing of the casing, the second case member having a packing portion in sliding contact with an inner periphery of the first case member when the second case member is moved for closing of the casing.

The second case member may be rotatably mounted on the first case member.

The first case member may have a box form with an opening to be closed by the second case member and the packing portion.

The first case member may have a shaft and the second case member may be rotatably fixed to the shaft.

The first and second case members may be formed of a thermoplastic resin, and the packing portion may be formed of a thermoplastic elastic resin.

The invention disclosed herein will be understood better with reference to the following drawings in which Figures 1-9 and 12-22 illustrate examples usefull for understanding the invention, and Figures 10, 11a and 11b only show an embodiment of the invention. Like reference numerals refer to like elements.

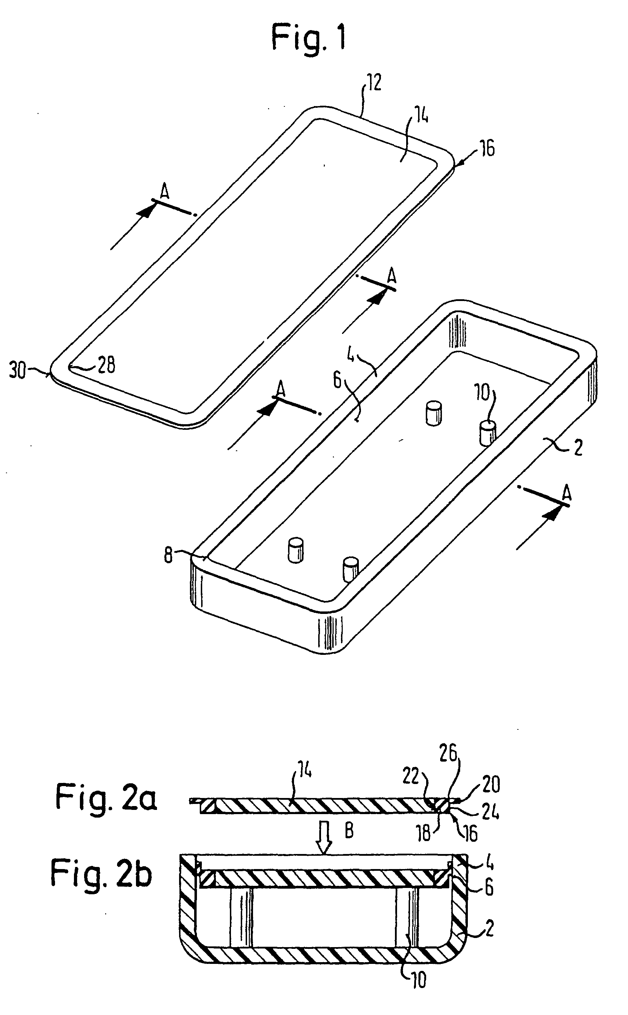

- Fig. 1: is a perspective view of an example of an electronic equipment casing.
- Fig. 2(a) and 2(b): are cross-sectional views of the electronic equipment casing taken along the line A-A of Fig. 1.

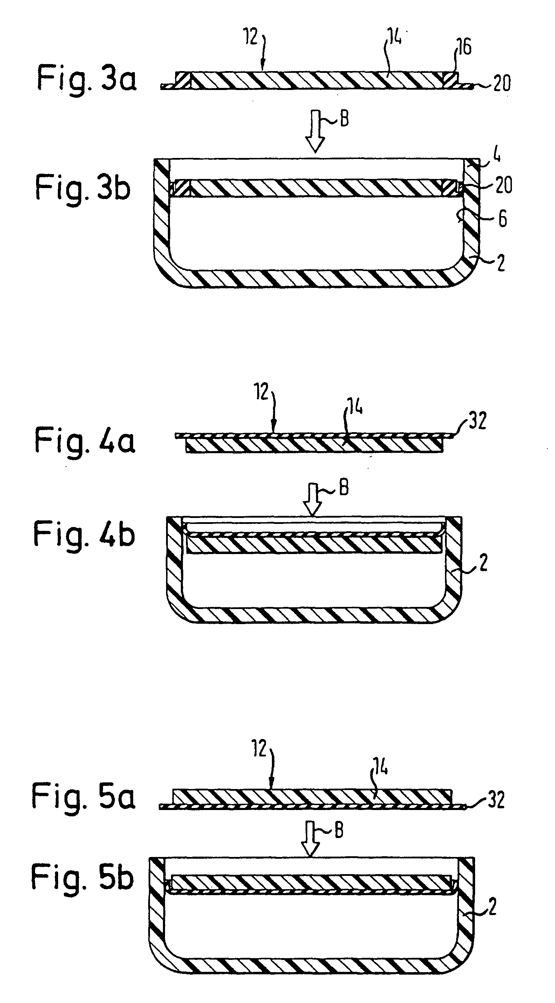

- Fig. 3(a) and 3(b): are cross-sectional views of another example of electronic equipment casing.
- Fig. 4(a) and 4(b): are cross-sectional views of another example of electronic equipment casing.
- Fig. 5(a) and 5(b): are cross-sectional views of another example of electronic equipment casing.

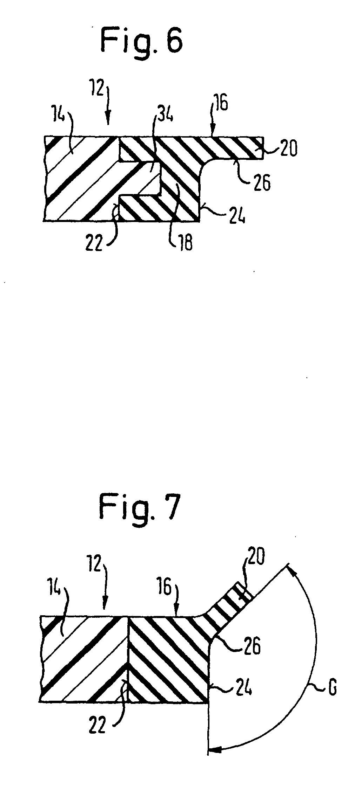

- Fig. 6: is an enlarged cross-sectional view of another example of electronic equipment casing.
- Fig. 7: is an enlarged cross-sectional view of another example of electronic equipment casing.

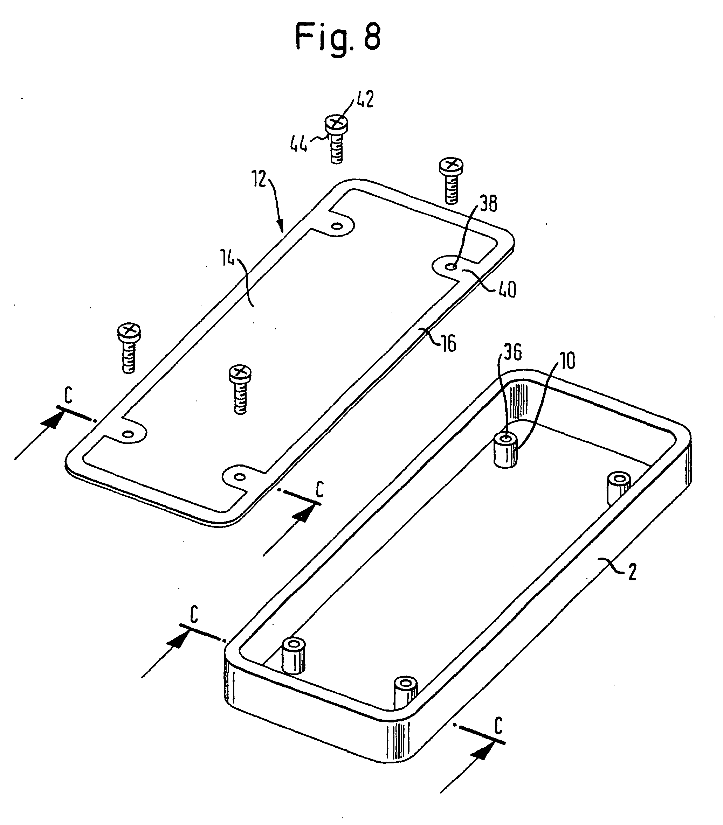

- Fig. 8.: is a perspective view of another example of the electronic equipment casing.

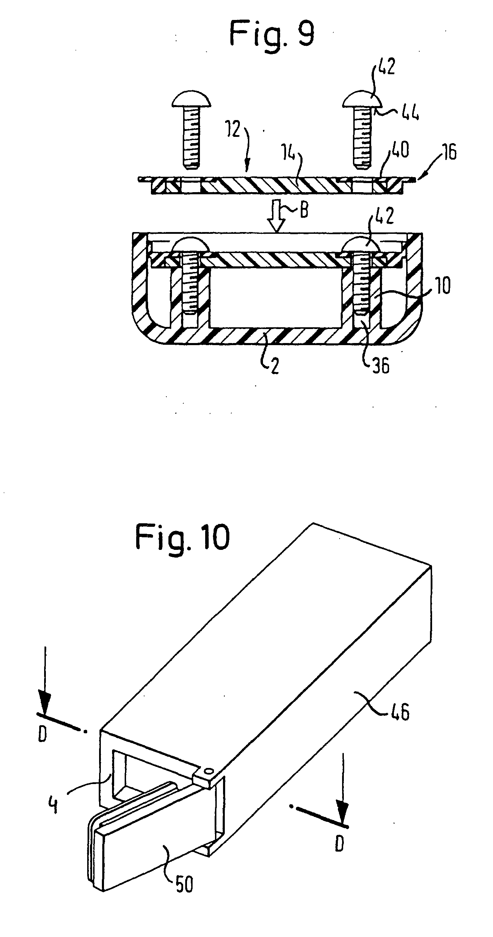

- Fig. 9: is a cross-sectional view of the electronic equipment casing taken along the line C-C of Fig. 8.
- Fig. 10: is a perspective view of an embodiment of the electronic equipment casing according to the present invention.

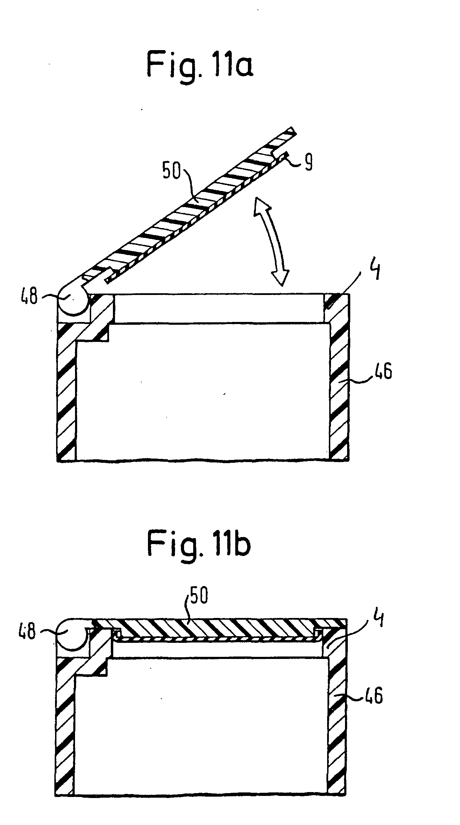

- Fig. 11(a) and 11(b): are cross-sectional views of the electronic equipment casing taken along the line D-D of Fig. 10.

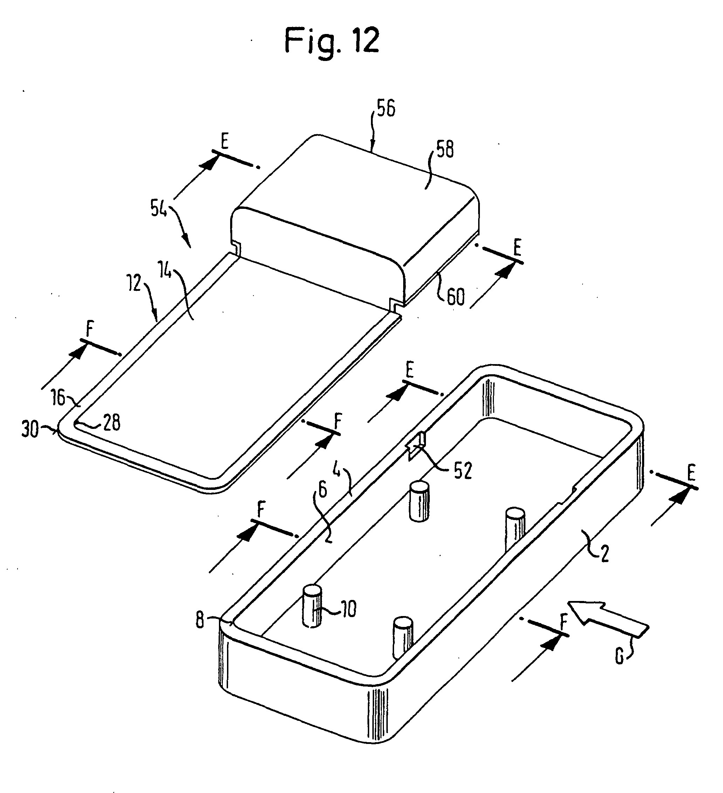

- Fig. 12: is a perspective view of another example of electronic equipment casing.

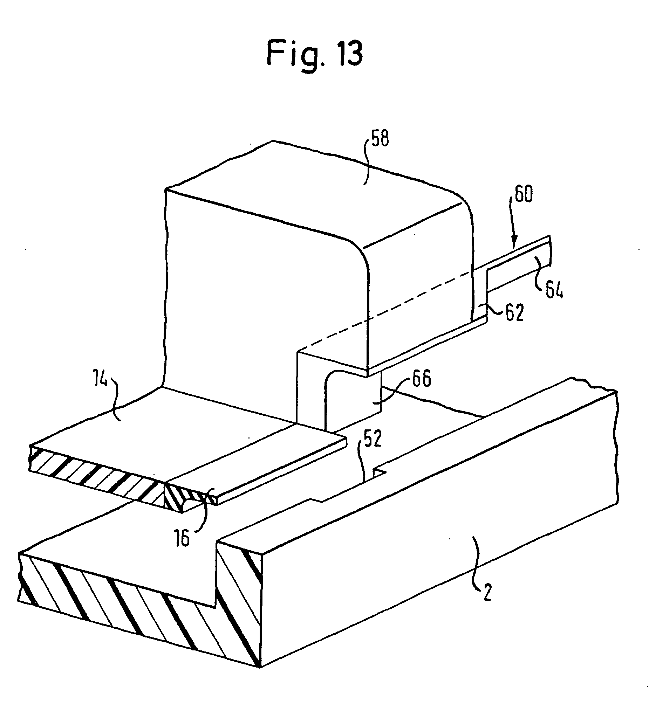

- Fig. 13: is a perspective view of part of the electronic equipment casing shown in Fig. 5.

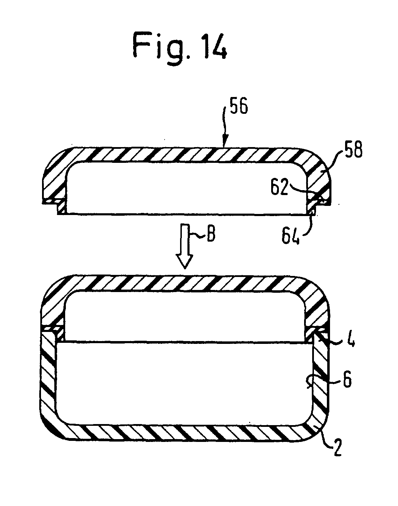

- Fig. 14: is a cross-sectional view of the electronic equipment casing taken along the line E-E of Fig. 12.

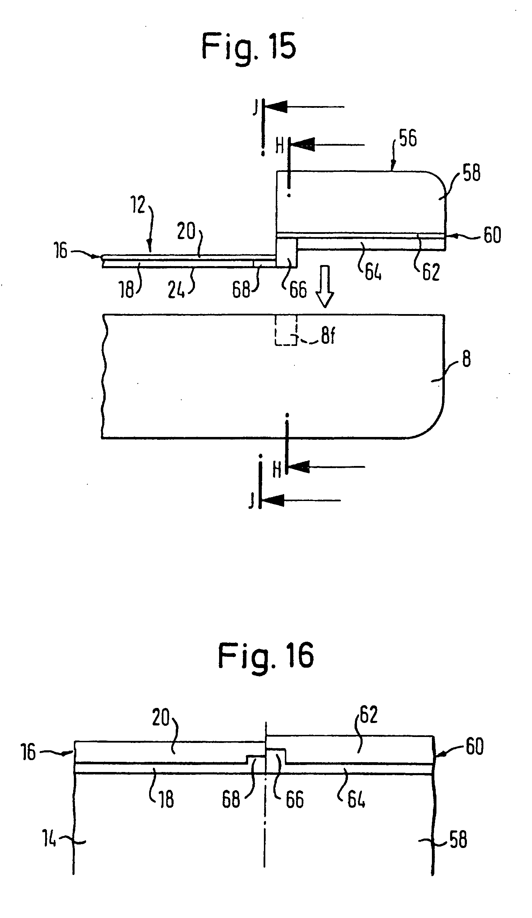

- Fig. 15: is a partial side view of the electronic equipment casing looking in the direction of arrow G in Fig. 12.
- Fig. 16: is a partial end view of the electronic equipment casing looking upwards from beneath the upper case (second case member) of Fig. 12.

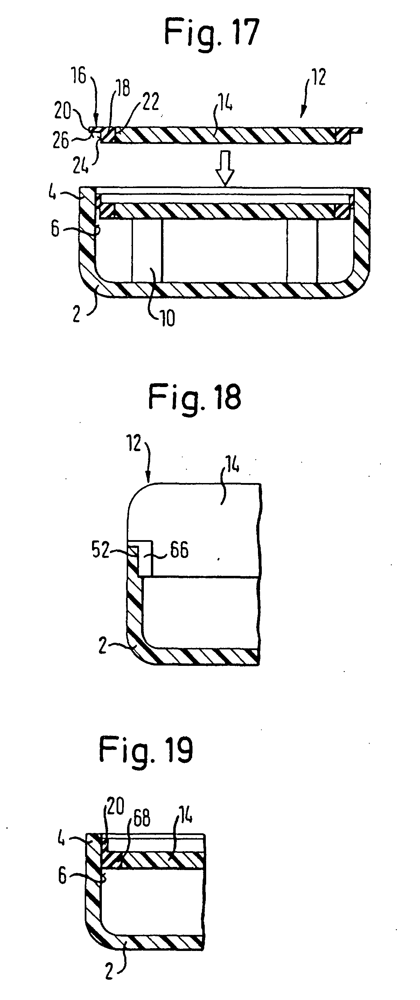

- Fig. 17: is a cross-sectional view of the electronic equipment casing taken along the line F-F of Fig. 12.
- Fig. 18: is a cross-sectional view of the electronic equipment casing taken along the line H-H of Fig. 15.
- Fig. 19: is a cross-sectional view of the electronic equipment casing taken along the line J-J of Fig. 15.

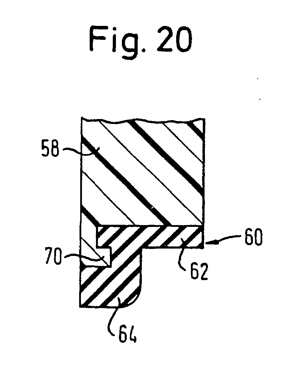

- Fig. 20: is an enlarged cross-sectional view of another example of electronic equipment casing.
- Fig. 21: is a perspective view of a conventional electronic equipment casing.
- Fig. 22: is a cross-sectional view of the conventional electronic equipment shown in Fig. 21.

### DESCRIPTION OF THE ILLUSTRATIVE EXAMPLES

Examples will be described in further detail by references to the accompanying drawings.

Fig. 1 is a perspective view of an example of electronic equipment casing. Figs. 2(a) and 2(b) are cross-sectional views taken along the line A-A of Fig. 1.

In the example, the casing is divided in two parts, i.e., a lower case member (first case member) and an upper case member (second case member). In the Figures, there is shown a lower case member (2) in a box shape with an upside opening. The lower case member (2) has a rim portion (4), and its inner wall portion (6) is to receive an upper case member. The lower case member (2) has rounded portions (8) at its four corners. From an inner bottom surface of the lower case member (2), protrusions (10) extend to receive an upper case member which is to be described later. The lower case member (2) is generally made of a thermoplastic resin.

Facing the lower case member (2), there is shown an upper case member (12) composed of a plate member (base portion) (14) and a sealing or packing member (packing portion) (16). The plate member (14) is generally made of a thermoplastic resin and the packing member (16) is preferably made of a thermoplastic elastic resin formed integrally with the plate member (14).

The packing member (16) protrudes from the entire periphery of the end surface of the plate member (14) and is composed of a base portion (18) and a sheet portion (20) as is apparent in Fig. 2(a). The sheet portion (20) extends outwards from the base portion (18) in a thin plate form. The base portion (18) of the packing member (16) is joined to the end surface of the plate (14) at joint surface (22). The outer end surface (24) of the base portion (18) extends to the sheet portion (20) through round corner portion (26).

The upper surfaces of the plate member (14) and the packing member (16) are level. The base portion (18) of the packing member (16) has the same thickness as the plate member (14) and the sheet portion (20) is thinner than the base portion (18).

The plate member (14) has rounded portions (28) at the corners in the horizontal plane and the packing member (16) also has corresponding rounded portions (30).

The areal dimensions of the opening of the lower case member (2) are larger than the areal dimensions of the plate member (14) of the upper case member (12) and are smaller than the areal dimensions of the upper case member (12) with the packing member (16). In the same context, the areal dimensions of the rounded portions (8) of the lower case member (2) are greater than those of the rounded portions (28) and less than those of the rounded portions (30) of the upper case member.

In assembly or operation, the upper case member (12) is brought into engagement with the lower case member (2) in the direction as shown by the arrow B in Fig. 2(a). The upper case member (12) and the lower case member (2) are shown engaged in Fig. 2(b).

When the upper case member (12) and the lower case member (2) are brought into engagement, the outer end surface (24) of the packing member (16) fits along the entire periphery of the inner wall portion (6) of the lower case member (2).

Since the areal dimensions of the upper case member (12) including the packing member (16) are larger than the dimensions of the opening of the lower case member (2), the sheet portion (20) is bent along the inner wall portion (6) and is deflected in the opposite direction of the engagement. The sheet portion (20) thus applies a deflection load to the inner wall portion (6).

The sealing contact of the sheet portion (20) with the inner wall portion (6) prevents entry of water droplets into the casing from the outside. The force with which the sheet portion (20) is in contact with the inner wall portion (6) can be varied by varying the thickness of the sheet portion (20).

The round structure of the corner portion (26) of the packing member (16) prevents breakage of the sheet portion (20), even when the sheet portion (20) is bent and concentrated stress is applied to the corner.

The radius of the rounded portion (8) is adjustably chosen. If the radius of the rounded portion (8) is too small, the sheet portion (20) is irregularly bent and may not be suitably fitted along the wall portion (6). The larger the radius of the rounded portion (8) is, the more the sheet portion (20) is fitted at the rounded portion (30) along the inner wall (6).

To manufacture the electronic equipment casing, thermoplastic material is preferably used. To manufacture the upper case member (12), a thermoplastic resin as the material of the plate member (14) and a thermoplastic elastic resin as the material of the packing member (16) are heat bonded to each other by injection molding.

Alternatively, two-colour molding (double molding) is performed. That is, after the packing member (16) is inserted into an injection molding die of the plate member (14) or after the plate member (14) is inserted into an injection molding die of the packing member (16), the plate member (14) and the packing member (16) are heat bonded to each other to make them into one unit by, for example, injection molding.

In the waterproof structure of the casing of this example, the thickness of the casing can be readily reduced, because the height or thickness of the upper case member (12) is not added on top of the lower case member (2) as is the case with the conventional casing shown in Fig. 21 and 22.

Further, since the packing member (16) is formed integrally with the plate member (14) in the upper case member (12), the number of parts can be reduced and the assembly can be simplified.

There is shown another example in the cross-sectional view of Fig. 3(a) and 3(b).

In this example, an upper case member (12) has a plate member (14) and a packing member (16) joined upside down compared with Fig. 2(a) and 2(b). That is, the sheet portion (20) of the packing member (16) is extended at the lower surface of the plate member (14).

There is shown another example in a cross-sectional view of Fig. 4(a) and Fig. 4(b).

In this example, the upper case member (12) in Fig. 4(a) is brought into engagement with the lower case member (2) as shown in Fig. 4(b).

The upper case member (12) is composed of a plate member (14) and a sheet member (32) overlapping and integrally joined over the plate member (14). The sheet member (32 is larger in its areal dimensions than the plate member (14) and extends outward over the entire periphery of the plate member (14). The sheet member (32) is preferably made of a thermoplastic elastic resin.

The upper case member (12) in this example can be manufactured by press molding or RIM molding. Therefore, the choice of manufacturing methods is increased. Thus, the sheet member (32) can be formed of rubber, such as silicone rubber.

There is shown another example in the cross-sectional view of Fig. 5(a) and 5(b)

In this example, an upper case member (12) has a packing sheet member (32) joined to the plate member (14) on the opposite side compared with Fig. 4(a) and (b). That is, the packing sheet member (32) is joined over the lower surface of the plate member (14).

This example is advantageous for joining the sheet member (32) to the plate member (14, since a force is applied to the sheet member (32) in a direction which secures the binding when upper and lower case members are engaged with each other.

There is shown another example in Fig. 6. This is an enlarged partial cross-sectional view of an upper case member (12).

A plate member (14) of the upper case member (12) has a protruding portion (34) which extends from the end surface (22) into the packing member (16). In this way, the packing member (16) is heat bonded to the plate member (14) through a larger interface so that the heat bonding strength between the packing member (16) and the plate member (14) is increased. Consequently, the packing member (16) does not readily peel off the plate member (14).

There is shown another example in Fig. 7, which is an enlarged partial cross-sectional view of an upper case member.

In this example, the packing member (16) of the upper case member (12) has an inclined sheet portion (20). The sheet portion (20) extends at an angle G with reference to the outer end surface (24) and the angle G can be more than 90 degrees and less than 180 degrees.

In this way, the resisting force of the sheet portion (20) can be adjusted. Further, the upper case member (12) can be readily brought into engagement with the lower case member (2).

There is shown another example in Fig. 8 and Fig. 9. This shows one way to secure the separate parts, i.e. a lower case member and an upper case member Fig. 9 is a sectional view taken along the line C-C of Fig. 8.

In this example, the lower case member (2) has four projections (10) with threaded recesses (36). The upper case member (12) has four holes (38) which are coaxial with the corresponding recesses (36) of the lower case member (2). Each hole is surrounded by packing portion (40) which extends from the peripheral packing member (16) over the plate member (14). The packing portion (40) is level with the surface of the plate member (14) and is thinner than the plate member (14).

When the upper case member (12) is brought into engagement with the lower case member (2), each screw (42) is inserted into the hole (38) and screwed into the round hole (36) and the screw head portion (44) of the screw (42) presses the packing portion (40).

In this way, entry of water droplets is prevented from coming in through the round hole (38) of the upper case member (12). This example provides a waterproof structure even when the electronic equipment casing is to be fixed by means of screws.

There is shown another example in Fig. 12 through Fig. 19. A case is formed in such a manner that a battery pack can be mounted on a plate portion thereof.

In this example, the lower case member (2) has a box shape with an upside opening and a pair of recesses (52) on the inner side (6) of the wall rim (4) as shown in the perspective view of Fig. 12.

The upper case member (12) is composed of a box type portion (56) and a flat plate portion (54) as shown in Fig. 12. Fig. 13 is an enlarged partial perspective view of the joining area of the box type portion (54) and the flat plate portion (54).

The box type portion (56) has downside opening and is composed of a case portion (58) and a packing portion (60) joined thereto.

The packing portion (60) has a generally L-shape in cross section as shown in the cross-sectional view of Fig. 14, which is taken along the line E-E of Fig. 12. The packing portion (60) has a flat base portion (62) and a guide portion (64).

At the interface with the flat plate portion (54), the packing portion (60) has a projection (66) as shown in Fig. 13. The projection (66) is thicker than the guide portion (64) and long enough to reach the flat plate portion (54), as seen in Fig. 15, which is a partial side view taken in the direction of arrow G of Fig. 12, and as seen in Fig. 16, which is partial end view from the lower side of the upper case member (12).

The flat plate portion (54) of the upper case member (12) generally has a similar shape as the previous example as explained with respect to Fig. 2(a), as shown in the cross-sectional view of Fig. 17 taken along the line F-F of Fig. 12. The flat plate portion (54) has a plate member (14) and packing member (16). At the interface with the box type portion (56), the packing member (16) has a projection (68), as seen in Fig. 15 and Fig. 16. The projection (68) is thicker than the base portion (18) but less thick than the projection (66) of the packing portion (60).

The packing portion (60) and the packing member (16) continuously extend with respect to each other and are formed integrally with the case portion (58) and plate member (14), respectively. The packing portion (60) and the packing member (16) are preferably made of a thermoplastic elastic resin.

The box type portion (56) of this example operates as follows.

When the upper case member (12) is brought into engagement with the lower case member (2), the guide portion (64) of the packing portion (60) slides and contacts against the inner wall portion (6) of the lower case member (2) and the packing portion (60) is pressed against the lower case member (2), so that no space is formed.

The recess (52) has the same form as the projection (66) or a slightly smaller size than the projection (66) so that the projection (66) can be fit into this, and no space is formed therebetween, as shown in Fig. 18, which is a cross-sectional view taken along the line H-H of Fig. 15.

The flat plate portion (54) of the upper case member (12) works in a similar way as in the previous example of Fig. 2(a) and 2(b), as shown in Fig. 17. At the interface area with the box type portion (56), the projection (68) presses against the inner wall portion (6) as shown in Fig. 19, which is a cross-sectional view taken along the line J-J of Fig. 15, and no space is formed.

Along the interface between the box type portion (56) and flat plate portion (54), the projection (66) of the packing portion (60) and the projection (68) of the plate portion packing (16) are formed continuously and integrally and pressed against the lower case member (2) so that no space is formed therebetween. Therefore, entry of water droplets into the casing from the outside is prevented.

This example assures a waterproof structure for the electronic equipment casing where either of the separate case members is partially formed in a box-like shape from the necessity of design or due to the parts mounted in the casing.

Modifications of this example of the flat plate portion (54) of the upper case member (12) can include waterproof shown in the previous examples.

There is shown another example in Fig. 20, which is an enlarged partial cross-sectional view of an upper case member. This example is a modification of the box type portion (56) of the upper case member (12) of Fig. 12.

In this example, a case portion (58) of a box type portion (56) has a protruding portion (70) which extends in a hook-like shape into the guide portion (64) of the packing portion (60).

In this way, the packing portion (60) is heat bonded to the case portion (58) through a larger interface, so that the heat bonding strength between the packing portion (60) and the case portion (58) is increased. Consequently, the packing portion (60) does not readily peel off the case portion (58).

### SUMMARY OF THE INVENTION

An object of the present invention is to provide a waterproof casing structure for electronic equipment.

Other and further objects, features and advantages of the invention will appear more fully from the following description of preferred exemplary embodiments of the present invention.

There is shown embodiment of the present invention in Fig. 10 and Fig. 11(a) and 11(b).

This embodiment shows a casing structure which has a mounted movable lid 50 as shown in a perspective view of Fig. 10. A first case member (46) is provided with a rotary shaft (48) as shown in Fig. 11(a), in the open lid state, and in Fig. 11(b), in the closed lid state, which are both cross-sectional views taken along the line D-D of Fig. 10.

The lid or second case member (50) is rotatably mounted on the shaft (48). The waterproof structure of the lid (50) is similar to that in Fig. 5(a) and 5(b) with a packing portion or sheet member 9 corresponding to packing sheet member 32 thereof, and similarly preferably made of a thermoplastic elastic resin, for example, or formed by similar techniques to that described.

It is understood that the foregoing description is of a preferred embodiment of the disclosed device and that various changes and modifications may be made within the scope of the appended claims.

Reference signs in the claims are intended for better understanding only and shall not limit the scope of the claims.

## Claims

1. A waterproof casing for electronic equipment, said casing comprising:
a first case member (46) provided with an opening defining a rim portion (4) in said first member; and
a second case member (50) engageable with the first case member for closing said opening to form a casing for accommodation;
and wherein the second case member (50) comprises a lid rotatably mounted on the first case member (46), the second case member (50) having a packing sheet (9) joined over the lower surface of the lid (50), said sheet being larger than the dimensions of the opening; a sheet portion being in sliding contact with an inner periphery of said rim portion (4) and deflected in the opposite direction of the engagement when the second case member is moved for closing of the casing.

2. The waterproof casing according to claim 1, wherein the first case member (46) has a shaft (48) and the second case member is rotatably fixed to the shaft.

3. The waterproof casing according to any one of claims 1 to 2, wherein the first and second case members are formed of a thermoplastic resin, and wherein the packing portion is formed of a thermoplastic elastic resin.

## Patentansprüche

1. Wasserdichtes Gehäuse für elektronische Geräte, welches Gehäuse folgendes aufweist:
ein erstes Gehäuseelement (46) mit einer Öffnung, die einen Kantenbereich (4) in dem ersten Gehäuseelement (46) definiert, und
ein zweites Gehäuseelement (50), das mit dem ersten Gehäuseelement (46) zum Verschließen dieser Öffnung in Eingriff bringbar ist, um ein Gehäuse für die Unterbringung auszubilden,
wobei das zweite Gehäuseelement (50) einen drehbar an dem ersten Gehäuseelement (46) angebrachten Deckel aufweist und eine Dichtungsmaterialbahn (9) hat, die über die untere Oberfläche des Deckels (50) hinüber angebracht ist, welche Materialbahn größer ist als die Abmaße der Öffnung, und
wobei ein Bereich der Materialbahn in gleitendem Kontakt mit einem Innenumfang des Kantenbereichs (4) ist und in der dem Eingriff entgegengesetzten Richtung ausgelenkt wird wenn das zweite Gehäuseelement zum Verschließen des Gehäuses bewegt wird.

2. Gehäuse nach Anspruch 1, bei welchem das erste Gehäuseelement (46) eine Welle (48) hat und das zweite Gehäuseelement (50) drehbar an dieser Welle angebracht ist.

3. Gehäuse nach einem der Ansprüche 1 und 2, bei welchem das erste (46) und das zweite Gehäuseelement (50) aus einem thermoplastischen Kunstharz gemacht ist sind und der Dichtungsbereich aus einem thermoplastischen elastischen Kunstharz gemacht ist.

## Revendications

1. Boîtier étanche pour équipement électronique, ledit boîtier comprenant :
un premier élément de coffret (46) muni d'une ouverture définissant une partie de rebord (4) dans ledit premier élément ; et
un second élément de coffret (50) pouvant être mis en prise avec le premier élément de coffret pour fermer ladite ouverture pour former un boîtier pour réception ;
et dans lequel le second élément de coffret (50) comprend un couvercle monté avec faculté de rotation sur le premier élément de coffret (46), le second élément de coffret (50) comportant une feuille de rembourrage (9) placée sur la surface inférieure du couvercle (50), ladite feuille étant plus large que les dimensions de l'ouverture ; une partie de la feuille étant en contact coulissant avec une périphérie interne de ladite partie de rebord (4) et déformée dans la direction opposée de la mise en prise, lorsque le second élément de coffret est déplacé pour fermeture du boîtier.

2. Boîtier étanche selon la revendication 1, dans lequel le premier élément de coffret (46) comporte un axe (48) et le second élément de coffret est fixé en rotation à l'axe.

3. Boîtier étanche selon l'une quelconque des revendications 1 et 2, dans lequel les premier et second éléments de coffret sont formés d'une résine thermoplastique, et dans lequel la partie de rembourrage est formée d'une résine élastique thermoplastique.
